# NEW EUROPEAN PATENT SPECIFICATION

(11) **EP 1 653 484 B2**
(45) Date of publication and mention of the opposition decision: **02.12.2015**
(45) Mention of the grant of the patent: 08.08.2012
(21) Application number: 04747417.6
(22) Date of filing: 13.07.2004
(51) Int. Cl.: H01L 39/24, H01B 13/00

(54) **Method of producing a superconducting wire**
Verfahren zur Herstellung eines supraleitenden Drahtes
Procédé de fabrication d'un fil supraconducteur

(30) Priority: 06.08.2003 JP 2003287971
(43) Date of publication of application: 03.05.2006
(73) Proprietor: Sumitomo Electric Industries, Ltd., Osaka-shi, Osaka 541-0041 (JP)
(72) Inventor: FUJINO, Koso, Osaka-shi, Osaka 554-8511 (JP); OHMATSU, Kazuya, Osaka-shi, Osaka 554-8511 (JP); KONISHI, Masaya, Osaka-shi, Osaka 554-8511 (JP); HAHAKURA, Shuji, Osaka-shi, Osaka 554-8511 (JP)
(74) Representative: Kreutzer, Ulrich
(86) International application number: PCT/JP2004/009951
(87) International publication number: WO 2005/015575

(56) References cited:
- JP-A- 02 207 415
- JP-A- 02 248 304
- JP-A- 03 093 110
- JP-A- 06 068 726
- JP-A- 07 105 750
- US-A1- 2002 198 112
- US-B1- 6 251 834
- US-B1- 6 458 223
- T.G. TRUCHAN ET AL.: 'Preparation of Nickel Substrates for Coated Conductors' IEEE TRANSACTIONS ON APPLIED SUPERCONDUCTIVITY vol. 10, 2000, pages 1130 - 1133
- M. HANDBÜCKEN ET AL.: 'Stress and Strain in Epitaxy:theoretical concepts, measurements and applications', 2001, ELSEVIER, AMSTERDAM pages 173 - 200
- Anonymous, "DIFFRAC plus AbsorbDX Release 2001 USER'S MANUAL", Bruker Advanced S-Ray Solutions
- J. DENUL ET AL.: 'A Brite EuRam project status report: Multi-functional Flexible High Temperature Superconducting Tape (MUST)', vol. 1, 17 September 1999 pages 335 - 338
- S. KREISKOTT ET AL.: 'Continuous electropolishing of Hastelloy substrates for ion-beam assisted deposition of MgO' SUPERCONDUCTOR SCIENCE AND TECHNOLOGY vol. 16, 2003, pages 613 - 616
- Y. AKIN ET AL.: 'Textured CeO² Thin Films on Nickel Tape by Sol-Gel Process' IEEE TRANSACTIONS ON APPLIED SUPERCONDUCTIVITY vol. 13, 02 June 2003, pages 2563 - 2565
- A. GOYAL ET AL.: 'Conductors with controlled grain boundaries: An approach to the next generation,high temperature superconducting wire' JOURNAL OF MATERIALS RESEARCH vol. 12, 1997, pages 2924 - 2940
- B. HOLZAPFEL ET AL.: 'Heteroepitaxial growth of oxide buffer layers by pulsed laser deposition on biaxially oriented Ni and Ni-alloy tapes' INST. PHYS. CONF. SER. no. 167, 17 September 1999, pages 419 - 422
- J. R. GROVES ET AL.: '"Ion-Beam Assisted Deposition of Bi-axially Aligned MgO Template Films for YBCO coated conductors"' IEEE TRANSACTIONS OF APPLIED SUPERCONDUCTIVITY vol. 9, 1999, pages 1964 - 1966
- Patent Abstracts of Japan (PAJ) No. 02248308, corresponding to JP2-248304 A, cited by the International Search Report of International Patent Application PCT/JP2004/009951 underlying the contested patent. (1999)

## Description

### Technical Field

The present invention relates to producing superconducting wires including a planarized, textured metal substrate and an overlying superconducting layer or an overlying intermediate layer followed by a superconducting layer.

### Background Art

Since high temperature superconductor was discovered, high temperature superconducting wires have increasingly been developed for application to cables, current limiters, magnets and other similar electric power equipment. To obtain excellent high temperature superconducting wire, it is necessary to employ a significantly oriented superconducting layer.

To enhance a superconducting layer in orientation, it has been proposed to prepare a biaxially textured metal substrate and deposit thereon a superconducting layer or an intermediate layer followed by a superconducting layer (*see* for example non-patent documents 1-4).

Herein a metal substrate is implemented by a substrate formed of metal atoms biaxially oriented, i.e., a biaxially textured metal substrate is used, and on the substrate an intermediate layer is epitaxially grown to have the same biaxial texture as the substrate and on the intermediate layer a superconducting layer is epitaxially grown to have the same biaxial texture as the intermediate layer. This method can help to produce a high temperature superconducting wire including a superconducting layer having a biaxial texture suitable for superconduction.

Furthermore, whether the substrate is flat significantly affects the overlying superconducting layer or intermediate and superconducting layers in orientation. Accordingly, a superconducting wire is produced with a substrate having a surface small in roughness or planarized (*see* for example a patent document 1).

If the substrate is a biaxially textured metal substrate that has been planarized through some planarization process, however, the substrate disadvantageously has a surface layer extending to a depth of 300 nm losing biaxial texture, and a superconducting layer or intermediate and superconducting layers having biaxial texture suitable for superconduction cannot be obtained.
Patent Document 1: Japanese Patent No. 2803123
Non-Patent Document 1: J. H. Je et al, "Microstructure of RE2O3 layers on cube textured Ni substrates", Physica C, (2003), 384, pp.54-60.
Non-Patent Document 2: B. W. Kang et al, "Comparative study of thickness dependence of critical current density of YBa2Cu3O7-δ on (100) SrTiO3 and on rolling-assisted biaxially textured substrates", J. Mater. Res., Jul. 2002, Vol.17, No.7, pp.1750-1757.
Non-Patent Document 3: D. Eyidi et al, "Growth of CeO2 thin film deposited on biaxially textured nickel substrate", J. Mater. Res., Jan. 2003, Vol.18, No.1, pp. 14-26.
Non-Patent Document 4: Fujino et al, "Development of High-temperature Superconducting Thin Film Tape Using the ISD Method", SEI Technical Review, September 1999, No.155, pp.131-135.

US 6,458,223 B1 shows a method which comprises making an alloy comprising a first metal, a second metal different than the first metal, and at least one oxide former for use in a multilayer superconductor, wherein a total amount of oxide former in the alloy comprises at least about 0.5 atomic percent of the alloy, each oxide former is different than the first and second metals, the second metal is nickel, the alloy comprises at least about 25 atomic percent nickel, and the article has a biaxially textured surface.

US 2002/0198112 A1 shows depositing a superconducting layer on an epitaxial buffer layer, and depositing an epitaxial capping layer between the epitaxial buffer layer and the superconducting layer.

### Disclosure

### Problems to be Solved by the Invention

The present invention has been made to overcome the above disadvantage by providing a textured metal substrate having a surface layer with biaxial texture maintained while the substrate's surface is planarized to provide a highly superconducting wire with a method of claim1.

### Means

A superconducting wire includes a metal substrate and an overlying superconducting layer, wherein the metal substrate is a textured metal substrate planarized to have a surface layer extending from a surface thereof to a depth of 300 nm with a crystal axis offset relative to an orientation axis by at most 25°, and a surface roughness R_{P-V} of at most 150 nm. In the present superconducting wire the textured metal substrate can underlie an intermediate layer and the intermediate layer can underlie the superconducting layer.

The present invention provides a method of claim1 of producing a superconducting wire, including the steps of: planarizing a textured metal substrate to have a surface layer extending from a surface thereof to a depth of 3 00 nm with a crystal axis offset relative to an orientation axis by at most 25°, and a surface roughness Rₚ₋ᵥ of at most 150 nm; and depositing a superconducting layer on the textured metal substrate planarized.

In the present method the step of planarizing the textured metal substrate is performed by at least one of : mechanochemistry.

The present method can further includes the step of thermally treating the textured metal substrate in a reducing atmosphere at least once after the step of planarizing the textured metal substrate and before the step of depositing the superconducting layer on the textured metal substrate planarized.

Furthermore the present method can further include the steps of: depositing an intermediate layer on the textured metal substrate; and depositing the superconducting layer on the intermediate layer.

### Effects of the Invention

Thus in accordance with the present invention a textured metal substrate planarized to have a surface layer extending from a surface thereof to a depth of 300 nm with a crystal axis offset relative to an orientation axis by at most 25° and surface roughness Rₚ₋ᵥ of at most 150 nm can have deposited thereon a superconducting layer or an intermediate layer followed by a superconducting layer to provide a highly superconductive wire.

### Brief Description of the Drawings

Fig. 1A shows a method of producing a superconducting wire in the present invention at the step of planarizing a textured metal substrate.
Fig. 1B is an enlarged view of a portion B shown in Fig. 1A.
Fig. 1C shows the method of producing the superconducting wire in the present invention at the step of depositing an intermediate layer on the textured metal substrate.
Fig. 1D shows the method of producing the superconducting wire in the present invention at the step of depositing a superconducting layer on the intermediate layer.
Fig. 1E is an enlarged view of a portion E shown in Fig. 1D.
Fig. 2 illustrates a method employed in the present invention to planarize a textured metal substrate.
Fig. 3 illustrates another method employed in the present invention to planarize a textured metal substrate.

### Description of the Reference Signs

1: textured metal substrate, 1a: surface layer, 1b: internal layer, 2: intermediate layer, 3: superconducting layer, 10: superconducting wire, 11: planarization process, 20: mechanochemical polisher, 21: presser, 23: shaft of rotation, 24: polishing sheet platform, 25: polishing sheet feed roll, 26: polishing sheet takeup roll, 27: polishing sheet, 28: polishing slurry supplier, 29: polishing slurry, 30: electrolytic polisher, 31: substrate feed roll, 32: substrate immersion roll, 33: substrate takeup roll, 34: electrolytic cell, 35: negative electrode, 36: electrolyte

### Best Modes for Carrying Out the Invention

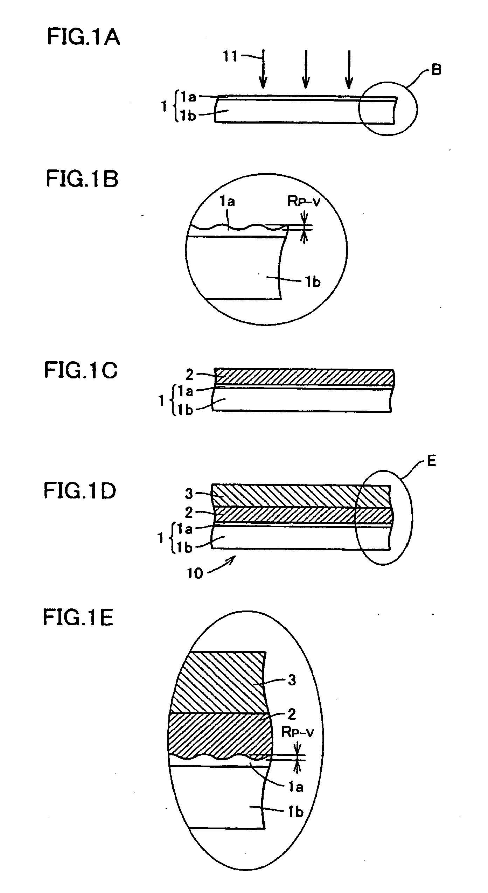

The present invention is a method which provides a superconducting wire, as shown in Figs. 1D and 1E, including a textured metal substrate 1, an intermediate layer 2 deposited on textured metal substrate 1, and a superconducting layer 3 deposited on intermediate layer 2. Textured metal substrate 1 from a surface thereof to a depth of 300 nm has a surface layer 1 a having a crystal axis offset relative to an orientation axis by at most 25°, and a surface roughness Rₚ₋ᵥ of 150 nm as it is planarized. As the textured metal substrate that has a surface layer with biaxial texture maintained and also has a surface planarized is used, an intermediate layer deposited thereon and a superconducting layer subsequently deposited thereon can be significantly biaxially textured layers, and a highly superconducting wire can thus be obtained. Note that when a polycrystal has a large number of crystal grains each having a particular direction as a crystal parallel to a particular axis, the axis is referred to as an orientation axis.

As employed in the present invention, textured metal substrate 1 indicates a metallic substrate formed of metal atoms biaxially oriented, and includes a perfectly biaxially textured substrate as well as a substrate having a crystal axis offset relative to an orientation axis by at most 25°. Herein in biaxial orientation two orientation axes indicate an axis approximately parallel to a crystal axis having a direction perpendicular to a plane of a substrate, and an axis approximately parallel to one crystal axis having a direction parallel to the plane of the substrate, and an offset angle in the substrate of a crystal axis relative to an orientation axis indicates an offset angle of one crystal axis extending in the direction parallel to the plane of the substrate relative to an orientation axis extending in a surface parallel to the plane of the substrate, and is indicated by an average of such offset angles in the substrate.

Furthermore an offset angle in the surface layer of a crystal axis relative to an orientation axis indicates an offset angle of one crystal axis extending in a direction parallel to a plane of the surface layer of the substrate relative to an orientation axis extending in a plane parallel to the plane of the surface layer, and is indicated by an average of such offset angles in the surface layer. In the surface layer a crystal axis offsets relative to an orientation axis by at most 25°. If in the surface layer the crystal axis offsets relative to the orientation axis by an angle exceeding 25°, significantly biaxially textured intermediate and superconducting layers cannot be obtained. As such, the surface layer has a crystal axis offset relative to an orientation axis more preferably by at most 12° and still more preferably at most 10°. Furthermore some types of textured metal substrates can dispense with the intermediate layer and may have the superconducting layer directly deposited thereon.

More specifically the present invention employs textured metal substrate 1 characterized in that, as described above, surface layer la extending from the substrate's surface to a depth of 300 nm has a crystal axis offset relative to an orientation axis by at most 25°, and surface roughness Rₚ₋ᵥ of 150 nm as the substrate is planarized. Even if an internal layer 1b (a layer in the substrate other than the surface layer) has a crystal axis offset relative to an orientation axis by at most 25°, surface layer 1a with a crystal axis offset relative to an orientation axis by an angle exceeding 25° or with surface roughness Rₚ₋ᵥ exceeding 150 nm prevents providing significantly biaxially textured intermediate and superconducting layers. Orientation is preferably provided in such a direction that a <100> axis is oriented in a direction perpendicular to the plane of the substrate and a <010> axis is oriented in a direction of the length of the substrate.

Herein surface roughness Rₚ₋ᵥ indicates a distance from the surface's highest crest to lowest trough between their respective apexes as seen in a direction perpendicular to the surface. Surface roughness Rₚ₋ᵥ is at most 150 nm. If surface roughness Rₚ₋ᵥ exceeds 150 nm, significantly biaxially textured intermediate and superconducting layers cannot be obtained. Furthermore the surface measured from such crests' apexes to such troughs' apexes in the direction perpendicular to the surface provides distances, which are averaged out to provide an average surface roughness Ra, which is preferably at most 50 nm in terms of providing surface roughness Rₚ₋ᵥ of at most 150 nm.

The textured metal substrate may be any substrate that is biaxially textured as described above. Preferably, however, Ni, Cr, Mn, Co, Fe, Pd, Cu, Ag, Au or an alloy of at least two thereof is used. Furthermore, not only the above metals or an alloy thereof alone but the above metals or the alloy thereof and another metal or an alloy thereof may also be arranged in layers. For example, stainless steel, a significantly strong material, provided with a textured Ni thin film layer may be used as the textured metal substrate.

In accordance with the present invention a superconducting wire is produced in a method, as described hereinafter. Initially, with reference to Figs. 1A and 1B, textured metal substrate 1 is planarized so that surface layer la extending from a surface of the substrate to a depth of 300 nm has a crystal axis offset relative to an orientation axis by at most 25°, and surface roughness Rₚ₋ᵥ of at most 150 nm. Then, with reference to Fig. 1C, substrate 1 has intermediate layer 2 deposited thereon. Furthermore, with reference to Figs. 1D and 1E, intermediate layer 2 has superconducting layer 3 deposited thereon. As textured metal substrate 1 that has a surface layer with biaxial texture maintained and also has a surface planarized is used, intermediate layer 2 deposited thereon and superconducting layer 3 further deposited thereon can be significantly biaxially textured intermediate and superconducting layers 2 and 3, and a highly superconducting wire can thus be obtained. Furthermore some types of textured metal substrates can dispense with the intermediate layer and may have the superconducting layer directly deposited thereon.

In Fig. 1C, textured metal substrate 1 has deposited thereon intermediate layer 2 formed preferably of a metal oxide containing at least one type of metal element and having pyrochlore, fluorite, halite, or provskite crystal structure. More specifically, CeO₂ or similar oxides of rare earth elements, yttrium stabilized zirconium (YSZ), BaZrO₃ (BZO), SrTiO₃ (STO), Al₂O₃, YAlO₃, MgO, a Ln-M-O based compound and the like are preferably used, wherein Ln represents at least one type of lanthanoid element, M represents at least one element selected from Sr, Zr and Ga, and O represents oxygen. Such oxides can contribute to a reduced difference between the textured metal substrate and the superconducting layer in crystal constant and crystal orientation and also prevent the substrate from having metal atoms flowing out into the layer. Furthermore, the intermediate layer may be formed of two or more layers. Note that if the textured metal substrate is for example a textured Ag substrate or a similar substrate having less metal atoms flowing out, the intermediate layer can be dispensed with and the substrate may have the superconducting layer directly deposited thereon.

The intermediate layer is formed of thin oxide film deposited by any method that is not contrary to the object of the present invention. Preferably, it is deposited by sputtering, electron beam deposition (EBD), pulse laser deposition (PLD), vapor deposition, and the like.

If textured metal substrate 1, e.g., a biaxially textured Ni substrate with <100> and <010> axes oriented in a direction perpendicular to a plane of the substrate and a direction of the length of the substrate, respectively, has intermediate layer 2 formed CeO₂ epitaxially grown thereon, a thin CeO₂ film is formed with <100> and <011> axes oriented in the direction perpendicular to the plane of the substrate and the direction of the length of the substrate, respectively. A significantly biaxially textured CeO₂ layer can thus be obtained.

In Fig. 1D, intermediate layer 2 may have any type of superconducting layer 3 deposited thereon. Preferably, however, RE₁Ba₂Cu₃O_{7-δ} or the like is used. The superconducting layer may be provided by any method that is not contrary to the object of the present invention. Preferably, it is deposited by PLD, metal organic deposition (MOD), metal organic chemical vapor deposition (MOCVD) or the like.

If intermediate layer 2, e.g., a biaxially textured CeO₂ layer with <100> and <011 > axes oriented in the direction perpendicular to the plane of the substrate and the direction of the length of the substrate, respectively, has superconducting layer 3 formed of Ho₁Ba₂Cu₃O_{7-δ} epitaxially grown thereon, a Ho₁Ba₂Cu₃O_{7-δ} layer is formed with <100> and <010> axes oriented in the direction perpendicular to the plane of the substrate and the direction of the length of the substrate, respectively. A significantly biaxially textured Ho₁Ba₂Cu₃O_{7-δ} layer can thus be obtained.

Furthermore, superconducting layer 3 may be protected by a protection layer deposited thereon, as required. The protection layer may be any layer that is highly conductive. Preferably, Ag, Au, Pt, Al or an alloy thereof is used. The protection layer may be formed in any method. Preferably, it is deposited by sputtering, EBD, PLD, thermal vapor deposition, MOD, MOCVD, plating, or the like.

In the present method before the substrate has the superconducting or intermediate layer deposited thereon at least one of: mechanochemistry; electrolytic polishing; and chemical polishing is used to provide textured metal substrate 1 planarized 11, as shown in Figs. 1A and 1B. The above method can provide textured metal substrate 1 planarized 11 while the surface layer 1 a biaxial texture is maintained.

A finished rolling employs a roll having a rolling surface mirror finished to roll the textured metal substrate to transfer the roll's mirror finished surface to a surface of the substrate to thus planarize the surface of the substrate.

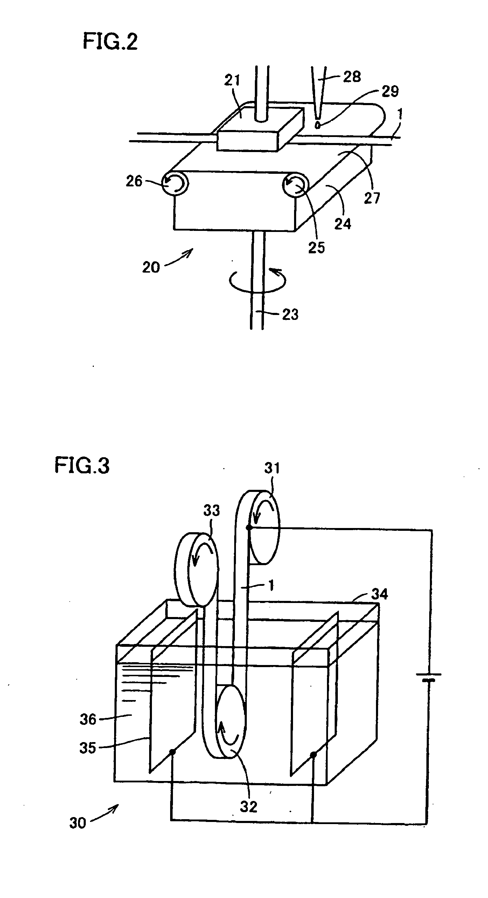

As referred to herein, mechanochemistry is performed as follows: for example, with reference to Fig. 2, a polishing slurry 29 formed of a corrosive, acidic or basic liquid with SiO₂, Al₂O₃ or similar abrasive grains dispersed therein is supplied from a polishing slurry supplier 28 while a presser 21 presses textured metal substrate 1 against a polishing sheet 27 to mechanically and chemically polish and thus planarize a surface of the textured metal substrate. Polishing sheet 27 is rotated as a polishing sheet platform 24 bearing the sheet is rotated by a shaft of rotation 23. Furthermore, polishing sheet feed and takeup rolls 25 and 26, respectively, rotate to feed an additional polishing sheet.

As referred to herein, electrolytic polishing is performed as follows: for example, with reference to Fig. 3, textured metal substrate 1 is immersed in an electrolyte 36 of concentrated phosphoric acid, concentrated sulfuric acid, or the like as a positive electrode, and between the positive electrode and a negative electrode 35 arranged in electrolyte 36 a direct current is passed to electrochemically polish a surface of textured metal substrate 1. The substrate is continuously, electrolytically polished and taken up by a substrate feed roll 31, a substrate immersion roll 32 and a substrate takeup roll 33.

As referred to herein, chemical polishing employs phosphoric acid, nitric acid, a hydrofluoric acid-nitric acid (HF-HNO₃) mixture solution, a hydrofluoric acid-oxygenated water (HF-H₂O₂) mixture solution, an oxalic acid-oxygenated water ((COOH)₂-H₂O₂) mixture solution or similar chemical polishing liquid and immerses the textured metal substrate therein to cause a chemical reaction to polish a surface of the substrate.

The present method between the step of planarizing the textured metal substrate and that of depositing the superconducting or intermediate layer on the planarized substrate can include the step of thermally treating the substrate in a reducing atmosphere at least once. One object of doing so is to remove an oxide layer formed on the surface layer of the textured metal substrate and expose the biaxially textured surface layer. Furthermore, if the planarized textured metal substrate has a surface layer impaired in biaxial texture, thermally treating the substrate in the reducing atmosphere can recover the surface layer in biaxial texture.

As described herein, thermally treating the planarized textured metal substrate in a reducing atmosphere indicates thermally treating the substrate in a reducing atmosphere that is sufficient to recover the surface layer's biaxial texture reduced as the substrate is planarized. For example, the substrate is thermally treated in the presence of H₂ or similar reductive gas. If the substrate is thermally treated in an atmosphere containing H₂ gas, it is preferable that the H₂ gas be larger in mole%, as such can contribute to more reduction. For example if the reductive gas is H₂ gas and Ar gas used together, the reductive gas preferably contains at least 1 mole%, more preferably at least 3 mole% of H₂ gas.

The present method between the step of planarizing the textured metal substrate and that of depositing the superconducting or intermediate layer on the planarized substrate can include the step of thermally treating the substrate in a vacuumed atmosphere at least once. One object of doing so is to remove an oxide layer formed on the surface layer of the textured metal substrate and expose the biaxially textured surface layer. Furthermore, if the planarized textured metal substrate has a surface layer impaired in biaxial texture, thermally treating the substrate in the vacuumed atmosphere can recover the surface layer in biaxial texture.

As described herein, thermally treating the planarized textured metal substrate in a vacuumed atmosphere indicates thermally treating the substrate in a vacuumed atmosphere that is sufficient to recover the surface layer's biaxial texture reduced as the substrate is planarized. For example, the substrate is thermally treated in a vacuumed atmosphere having a degree of vacuum of at most 1.33 × 10⁻² Pa.

The textured metal substrate is thermally treated in the reducing atmosphere at any temperature that is lower than the substrate's melting point. Preferably, the substrate is thermally treated at 500°C to 800°C. If the substrate is thermally treated at a temperature lower than 500°C, the substrate has a surface layer insufficiently recovered in biaxial texture. If the substrate is thermally treated at a temperature higher than 800°C, the substrate in its entirety can be reduced in biaxial texture. Accordingly, the substrate is thermally treated more preferably at 600°C to 700°C.

Preferably, the substrate is thermally treated for at least two minutes. If the substrate is thermally treated for less than two minutes, the substrate has a surface layer insufficiently recovered in biaxial texture.

The textured metal substrate is thermally treated in the reducing atmosphere in any manner. Preferably, however, it is so done immediately before it is provided thereon with the superconducting or intermediate layer, as such can prevent the thermally treated substrate from having a surface layer again reduced in biaxial texture. Furthermore the substrate may be thermally treated not only once but more than once to further recover the surface layer's biaxial texture. Furthermore if the substrate is thermally treated more than once it may undergo both the thermal treatment performed in the reducing atmosphere and that performed in the vacuumed atmosphere.

If the planarized textured metal substrate is thermally treated in the reducing atmosphere twice, i.e., preliminarily and immediately before the substrate is provided with the superconducting or intermediate layer, the substrate is preliminarily, thermally treated preferably in the atmosphere at 500°C to 800°C for at least two minutes, more preferably at least five minutes, most preferably at least ten minutes, and when the substrate is thermally treated immediately before the substrate is provided with the superconducting or intermediate layer, the substrate is thermally treated preferably in the atmosphere at 500°C to 800°C for at least two minutes, more preferably at least three minutes, most preferably at least seven minutes.

Hereinafter the present invention will be described with reference to specific examples:

### First Example

A biaxially textured metal substrate having a length of 40 cm, a width of 10 mm and a thickness of 100 µm and formed of Ni-Fe alloy having a composition of 50 mole% of Ni and 50 mole% of Fe was prepared. It had <100> and <010> axes oriented in a direction perpendicular to a plane of the substrate and a direction of the length of the substrate, respectively, and had a surface layer with a crystal axis offset relative to an orientation axis by at most 9°, and surface roughness R_{P-V} of 513 nm and average surface roughness Rₛ of 62 nm. The substrate skipped a primary planarization process and, with reference to Fig. 2, underwent a secondary planarization process. More specifically, an aqueous solution containing 3% by mass of hydrogen peroxide (H₂O₂) and having 36% by volume of abrasive grains of 72 nm in diameter dispersed therein was prepared as polishing slurry 29 (pH: 8.8) which was supplied while presser 21 exerted a load of 15/N cm² on textured metal substrate 1 and polishing sheet 27 was also rotated at 180 rpm to polish the substrate for three minutes. Furthermore, the substrate underwent a third planarization process. More specifically, an aqueous solution containing 1.4% by mass of H₂O₂ and having 30% by volume of abrasive grains of 12 nm in diameter dispersed therein was prepared as polishing slurry 29 (pH: 10.1) which was supplied while presser 21 exerted a load of 15/N cm² on textured metal substrate 1 and polishing sheet 27 was also rotated at 180 rpm to polish the substrate for three minutes.

The thus planarized textured metal substrate had a surface roughness R_{P-V} of 143 nm and an average surface roughness Rₐ of 16 nm, and had a surface layer with a crystal axis offset relative to an orientation axis by at most 9°. Note that surface roughness R_{P-V} and average surface roughness Rₐ were measured with an atomic force microscope and the angle was measured by x ray pole figure measurement.

Furthermore the thus planarized textured metal substrate's surface layer was evaluated for orientation in the (200) plane by low angle incidence x ray diffraction. More specifically, before and after the planarization the substrate underwent low angle incidence x ray measurement, and the measurement obtained after the planarization was compared with that obtained before the planarization for evaluation. "o" indicates that the (200) plane provided diffraction having a peak substantially maintained in relative intensity. "Δ" indicates that the (200) plane provided diffraction having a reduced peak and the (111) plane provided diffraction having a clearly manifesting peak. "×" indicates that the peak of diffraction from the (200) plane disappeared and the (111) plane provided diffraction having a peak substantially, relatively increased in intensity. Note that a peak of diffraction from the (200) plane relatively larger in intensity indicates increased biaxial texture. In the present embodiment the planarized textured metal substrate had a surface layer with a (200) plane providing an orientation evaluated "o".

The textured metal substrate was then thermally treated using a reductive gas formed of H₂ gas and Ar gas mixed together (composition: 3 mole% of H₂ gas and 97 mole% ofAr gas) in a reducing atmosphere of 1.33 Pa in pressure at a temperature for a period of time, as indicated in Table 1, twice preliminarily and immediately before the substrate was provided with the superconducting or intermediate layer. In the present embodiment the thus thermally treated textured metal substrate had a surface layer with a (200) plane providing an orientation evaluated "o".

Then immediately after the secondary thermal treatment a reductive gas containing H₂ gas and Ar gas mixed together (composition: 3 mole% of H₂ gas and 97 mole% of Ar gas) was used and the substrate was introduced in a reducing atmosphere of 1.33 Pa in pressure. The substrate's temperature was set at 650°C and thus subjected to sputtering to have thereon an intermediate layer of CeO₂ of 0.1 µm in thickness. The intermediate layer was evaluated for orientation in the (200) plane by low angle incidence x ray diffraction. "o" indicates that the (200) plane provided diffraction having a peak relatively large in intensity and the (111) plane did not provide diffraction having a peak. "Δ" indicates that the (200) and (111) planes both provided diffraction having a clearly manifesting peak. "x" indicates that the (200) plane did not provide diffraction having a peak and the (111) plane provided diffraction having a peak relatively large in intensity. In the present embodiment the intermediate layer had a surface layer with a (200) plane providing an orientation evaluated "o".

Furthermore, PLD was employed with a laser frequency of 150 Hz, laser energy of 0.65 J, O₂ gas having a pressure of 13.3 Pa, and the substrate and intermediate layer having a temperature of 750°C to deposit on the intermediate layer a superconducting layer formed of Ho₁Ba₂Cu₃O_{7-δ} and having a thickness of 0.5 µm to obtain a superconducting wire, which provided a critical current density of 0.1 1 MA/cm² in an atmosphere at 77 K for an external flux density of 0T. The result is indicated in Table 1.

### First Comparative Example

Except that it was not planarized, the textured metal substrate was thermally treated twice and provided with intermediate and superconducting layers, similarly as described in the first example. The result is indicated in Table 1.

### Second Comparative Example

The textured metal substrate was primarily planarized: textured metal substrate 1 received a load of 7 N/cm² and a #2000 paper (e.g., that having abrasive grains of 1 to 10 µm in diameter) was rotated at 180 rpm to polish the substrate for three minutes. Thereafter, as described in the first example, the substrate was secondarily and thirdly planarized, thermally treated in a reducing atmosphere twice, and provided with intermediate and superconducting layers. The result is shown in Table 1. Note that the planarized textured metal substrate had a surface layer with a crystal axis offset by an angle exceeding a measurement limit of 25° and thus unmeasured.

### Second Example

Except that it was secondarily planarized for nine minutes, rather than three minutes, the textured metal substrate was processed as described in the first example, secondarily and thirdly planarized, thermally treated in a reducing atmosphere twice, and provided with superconducting and intermediate layers. The result is shown in Table 1.

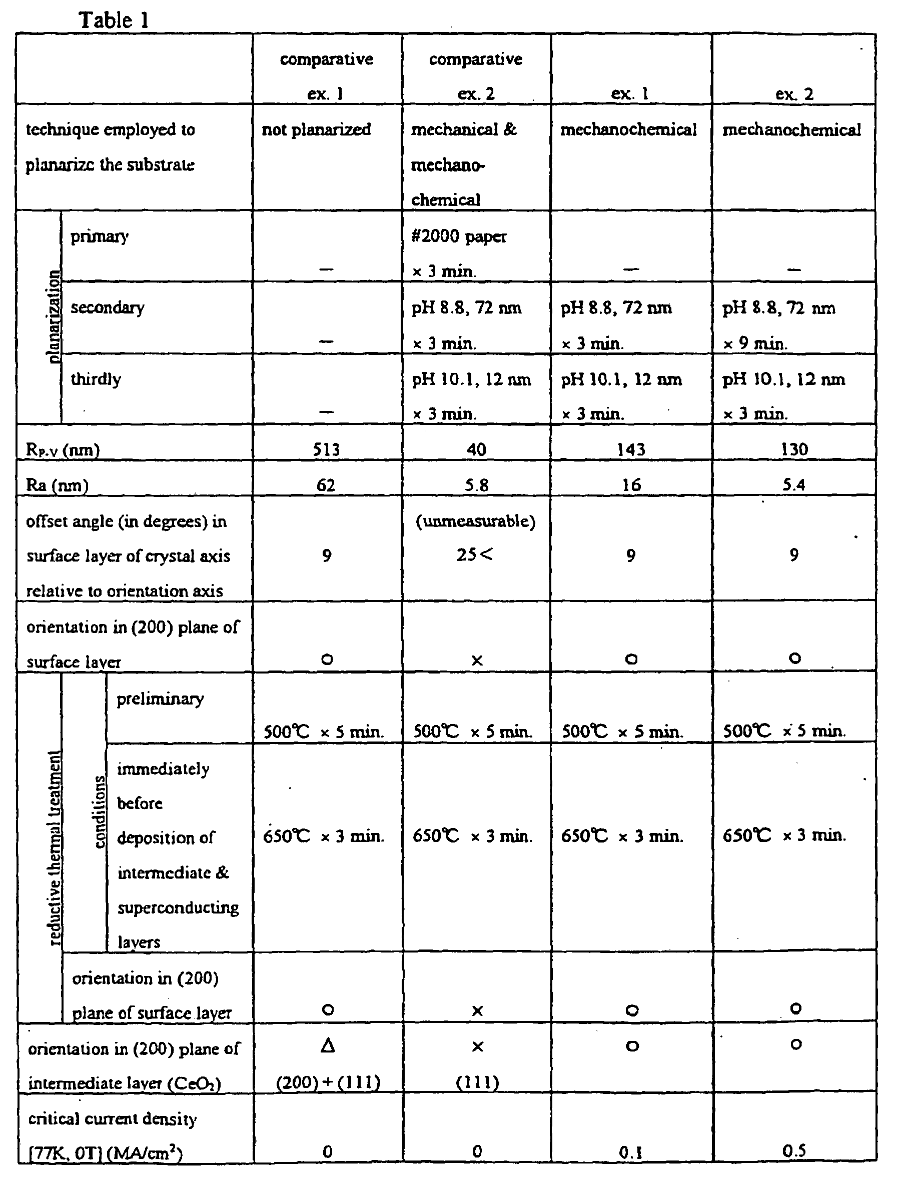

### Third to Sixth Examples

With reference to Fig. 2, a primary planarization process was performed as follows: an aqueous solution containing 4% by mass of aluminum nitrate (Al(NO)₃) and having 18% by volume of abrasive grains of 850 nm in diameter dispersed therein was prepared as polishing slurry 29 (pH: 3.4) which was supplied while presser 21 exerted a load of 15/N cm² on textured metal substrate 1 and polishing sheet 27 was also rotated at 180 rpm to polish the substrate for three or six minutes, as indicated in Table 2. Furthermore, the substrate was secondarily and thirdly planarized, as described in the second example. Furthermore, the substrate was thermally treated in a reducing atmosphere twice under the conditions shown in Table 2, and provided with intermediate and superconducting layers, similarly as described in the first example. The result is shown in Table 2.

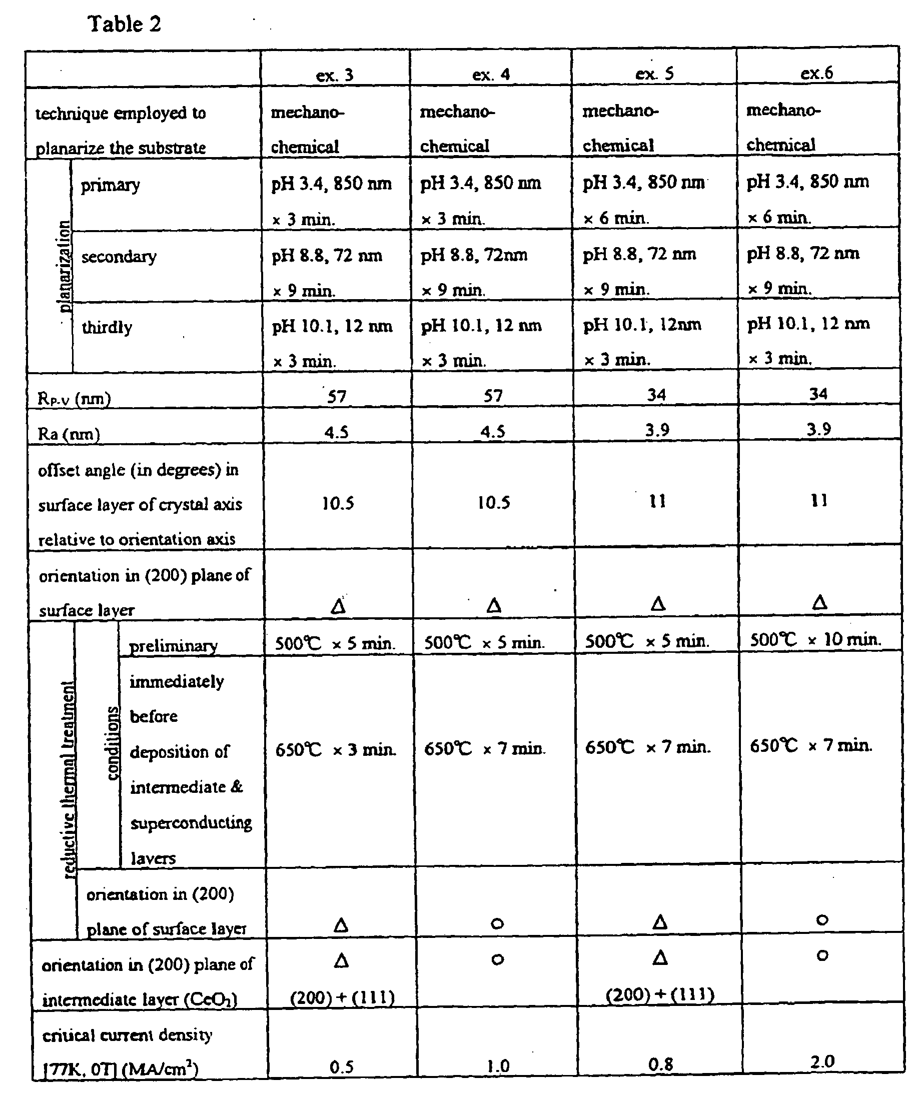

### Seventh and Eighth Examples

The substrate was primarily, secondarily and thirdly planarized, similarly as described in the fifth example. The substrate was then placed in a vacuumed atmosphere having a degree of vacuum of at most 1.33 × 10⁻² Pa, and thus thermally treated twice under the conditions shown in Table 3, and then provided with intermediate and superconducting layers, similarly as described in the first example. The result is shown in Table 3.

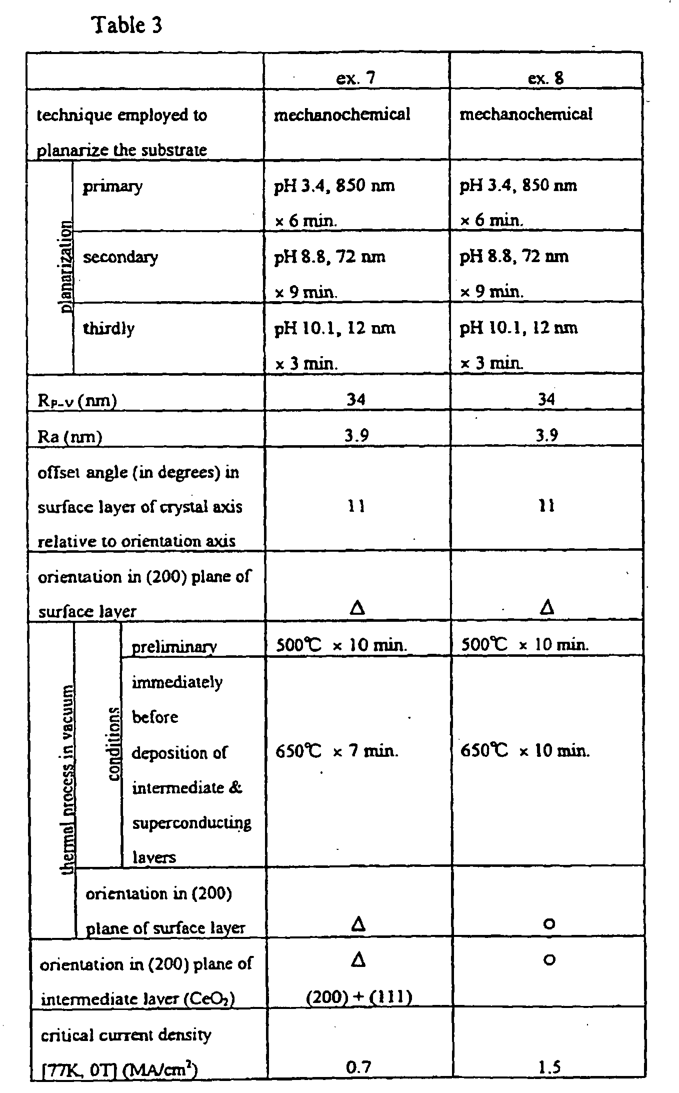

In the first comparative example the textured metal substrate had a surface layer having a crystal axis offset relative to an orientation axis by 9°, and also having a (200) plane providing significant orientation. However, it had surface roughness R_{P-V} larger than 150 nm, resulting in an intermediate layer having a (200) plane providing reduced orientation, and also providing a critical current density of 0 MA/cm². In the second comparative example the textured metal substrate had surface roughness R_{P-V} smaller than 150 nm. However, its surface layer provided a crystal axis offset relative to an orientation axis by an angle exceeding 25° and did not have a (200) plane providing orientation. This results in an intermediate layer having a (200) plane without orientation and also provided a critical current density of 0 MA/cm². Furthermore if planarizing the substrate resulted in a surface layer having a (200) plane completely losing orientation, thermally treating the substrate in the reducing atmosphere was unable to recover the surface layer's lost orientation.

By contrast, the first and second examples both provided a textured metal substrate with a surface layer having a crystal axis offset relative to an orientation axis by at most 25° and a (200) plane providing significant orientation, and also having surface roughness R_{P-V} of at most 150 nm. This allowed an intermediate layer to be formed with a (200) plane proving significant orientation, and significantly biaxially textured, and a superconducting layer to be significantly biaxially textured, and superconducting wires providing critical current densities of 0.1 MA/cm² and 0.5 MA/cm², respectively, were obtained.

Furthermore, as described in the third to sixth examples, if the textured metal substrate having been planarized had a surface layer having a crystal axis offset relative to an orientation axis by 10.5° to 11°, and a (200) plane providing reduced orientation, thermally treating the substrate in a reducing atmosphere was able to enhance the surface layer's orientation in the (200) plane unless it had completely been lost. This allowed an intermediate layer to be formed with a (200) plane providing significant orientation, and significantly biaxially textured, and a superconducting layer to be significantly biaxially textured, and superconducting wires providing critical current densities of 0.5 MA/cm² to 2.0 MA/cm² were obtained.

Furthermore, as described in the seventh and eighth examples, if planarizing the textured metal substrate resulted in a crystal axis offset by 11° and hence a surface layer having a (200) plane providing reduced orientation, thermally treating the substrate in a vacuumed atmosphere was also able to enhance the surface layer's orientation in the (200) plane unless it had completely been lost. This allowed an intermediate layer to be formed with a (200) plane providing significant orientation, and significantly biaxially textured, and a superconducting layer to be significantly biaxially textured, and superconducting wires providing critical current densities of 0.7 MA/cm² to 1.5 MA/cm² were obtained.

### Industrial Applicability

Thus the present invention is widely applicable to superconducting wires formed of a textured metal substrate and an overlying superconducting layer or an overlying intermediate layer followed by a superconducting layer and methods of production thereof to provide a significantly biaxially textured superconducting layer and hence a superconducting wire providing increased critical current density and enhanced superconduction.

## Claims

1. A method of producing a superconducting wire, comprising the steps of:
- planarizing a textured metal substrate (1) so that within a surface layer (1a) extending from a surface thereof to a depth of 300 nm an angle of a crystal axis offset relative to an orientation axis is at most 25° measured by X-ray pole figure measurement, and a surface roughness R_{P-V} of at most 150 nm measured with an atomic force microscope;
- depositing a superconducting layer (3) on said textured metal substrate (1) planarized; and
- thermally treating said textured metal substrate (1) in a reducing atmosphere at least once after the step of planarizing said textured metal substrate (1) and before the step of depositing said superconducting layer (3) on said textured metal substrate (1) planarized and to remove an oxide layer formed on the surface layer of the textured metal substrate,
wherein the step of planarizing said textured metal substrate (1) is performed by mechanochemistry.

2. The method according to claim 1, further comprising the steps of:
- depositing an intermediate layer (2) on said textured metal substrate (1); and
- depositing said superconducting layer (3) on said intermediate layer (2).

## Patentansprüche

1. Verfahren zur Herstellung eines supraleitenden Drahts, umfassend die Schritte des:
- Einebnens eines texturierten Metallsubstrats (1), so dass innerhalb einer Oberflächenschicht (1a), die von einer Oberfläche davon bis zu einer Tiefe von 300 nm reicht, ein relativ zu einer Orientierungsachse versetzter Winkel einer Kristallachse gemessen mittels Röntgenpolfigurmessung höchstens 25° beträgt und eine Oberflächenrauheit R_{P-V} gemessen mittels Rasterkraftmikroskop höchstens 150 nm beträgt; und
- Aufbringens einer supraleitenden Schicht (3) auf das eingeebnete texturierte Metallsubstrat (1) und
- Wärmebehandelns des texturierten Metallsubstrats (1) in einer reduzierenden Atmosphäre mindestens einmal nach dem Schritt des Einebnens des texturierten Metallsubstrats (1) und vor dem Schritt des Aufbringens der supraleitenden Schicht (3) auf das eingeebnete texturierte Metallsubstrat (1) und zum Entfernen einer auf der Oberflächenschicht des texturierten Metallsubstrats gebildeten Oxidschicht,
wobei der Schritt des Einebnens des texturierten Metallsubstrats (1) mittels Mechanochemie durchgeführt wird.

2. Verfahren nach Anspruch 1, ferner umfassend die Schritte des:
- Aufbringens einer Zwischenschicht (2) auf das texturierte Metallsubstrat (1); und
- Aufbringens der supraleitenden Schicht (3) auf die Zwischenschicht (2).

## Revendications

1. Procédé de production d'un fil superconducteur comprenant les étapes de :
- planarisation d'un substrat métallique texturé (1) de sorte que dans une couche superficielle (1a) se prolongeant d'une surface de celui-ci à une profondeur de 300 nm, un angle du décalage de l'axe du cristal par rapport à un axe d'orientation est d'au plus 25°, mesuré par une mesure d'une figure des pôles des rayons X, et une rugosité de surface R_{P-V} est d'au plus 150 nm, mesurée avec un microscope à forces atomiques ; et
- dépôt d'une couche superconductrice (3) sur ledit substrat métallique texturé (1) planarisé ; et
- traitement thermique dudit substrat métallique texturé (1) sous une atmosphère réductrice au moins une fois après l'étape de planarisation dudit substrat métallique texturé (1) et avant l'étape de dépôt de ladite couche superconductrice (3) sur ledit substrat métallique texturé (1) planarisé et pour éliminer une couche d'oxyde formée sur la couche de surface du substrat métallique texturé,
dans lequel l'étape de planarisation dudit substrat métallique texturé (1) est réalisée par polissage mécanochimique.

2. Procédé selon la revendication 1, comprenant en outre les étapes de :
- dépôt d'une couche intermédiaire (2) sur ledit substrat métallique texturé (1) ; et
- dépôt de ladite couche superconductrice (3) sur ladite couche intermédiaire (2).
